# EUROPEAN PATENT SPECIFICATION

(11) **EP 1 475 840 B1**
(45) Date of publication and mention of the grant of the patent: **19.07.2006**
(21) Application number: 03425292.4
(22) Date of filing: 07.05.2003
(51) Int. Cl.: H01L 27/24, H01L 45/00

(54) **Process for manufacturing a memory device having selector transistors for storage elements and memory device fabricated thereby**
Verfahren zur Herstellung einer elektrischen Speichereinrichtung mit Auswahltransistoren für Speicherelemente sowie entsprechend hergestellte Speichereinrichtung
Procédé de fabrication d'un dispositif mémoire comprenant des transistors de sélection pour des éléments de stockage et dispositif mémoire ainsi fabriqué

(43) Date of publication of application: 10.11.2004
(73) Proprietor: STMicroelectronics S.r.l., 20041 Agrate Brianza (Milano) (IT); Ovonyx Inc., Rochester Hills, Michigan 48309 (US)
(72) Inventor: Pellizzer, Fabio, 31051 Follina (IT); Bez, Roberto, 20146 Milano (IT)
(74) Representative: Cerbaro, Elena

(56) References cited:
- EP-A- 0 544 204
- EP-A- 1 318 552
- WO-A-00/57498
- US-A- 4 922 318
- US-A1- 2002 038 883

## Description

The present invention relates to a process for manufacturing a memory device having bipolar transistors as selectors for storage elements and to a memory device fabricated thereby.

As is known, memory devices comprise a plurality of memory cells or storage elements arranged in rows and columns, so as to form a memory array. Row and column decoders are used to selectively connect the storage elements to read/write circuits of the memory device for usual operation through. Moreover, in some cases it is necessary to provide further selection elements, which selectively activate and deactivate the storage elements for preventing disturbances caused by other adjacent storage elements.

To this aim, using bipolar transistors as selectors coupled to the storage elements is known as well. In particular, a bipolar selector transistor has a base terminal connected to a control line (e.g. a word line), an emitter terminal coupled to the storage element and a collector terminal normally connected to ground. It is clear that the way the emitter of the bipolar selector transistor and the storage element are coupled depends on the structure of the storage element itself.

For example, phase change memories are presently memory devices of increasing interest, which use bipolar transistors as selectors for storage elements.

Phase change memory cells utilize a class of materials that have the unique property of being reversibly switcheable from one phase to another with measurable distinct electrical properties associated with each phase. For example, these materials may change between an amorphous disordered phase and a crystalline, or polycrystalline, ordered phase. A material property that may change and provide a signature for each phase is the material resistivity, which is considerably different in the two states.

Specific materials that may be suitably used in phase change cells are alloys of elements of the VI group of the periodic table as Te or Se, also called chalcogenides or chalcogenic materials. Therefore, hereinafter, the term "chalcogenic materials" is used to indicate all materials switcheable between at least two different phases where they have different electrical properties (resistances) and include thus the elements of the VI group of the periodic table and their alloys.

In phase change memories, a thin film of chalcogenic material is employed as a programmable resistor, switching between a high and a low resistance condition.

Phase change is normally obtained by locally increasing the temperature. Under 150°C, both phases are stable. Over 200°C, nucleation of crystallites is fast and if the material is kept at the crystallization temperature for a sufficient time, it changes phase and becomes crystalline. In order to change the phase back to the amorphous state, its temperature is brought over the melting point (about 600°C) and the calcogenide is rapidly cooled.

From an electrical point of view, it is possible to reach both critical temperatures (crystallization and melting temperatures) causing an electric current to flow through a resistive electrode in contact or close proximity with the chalcogenic material and heating the material by Joule effect. This goal is achieved by causing such a current flow to pass through a suitable neighboring series resistor, that operates as a heater.

The state of the chalcogenic material may be read applying a sufficiently small voltage (or current) so as not to cause a sensible heating and measuring the current passing through it (or voltage across it). Since the current is proportional to the conductance of the chalcogenic material (or voltage is proportional to the resistance), it is possible to discriminate between the two states.

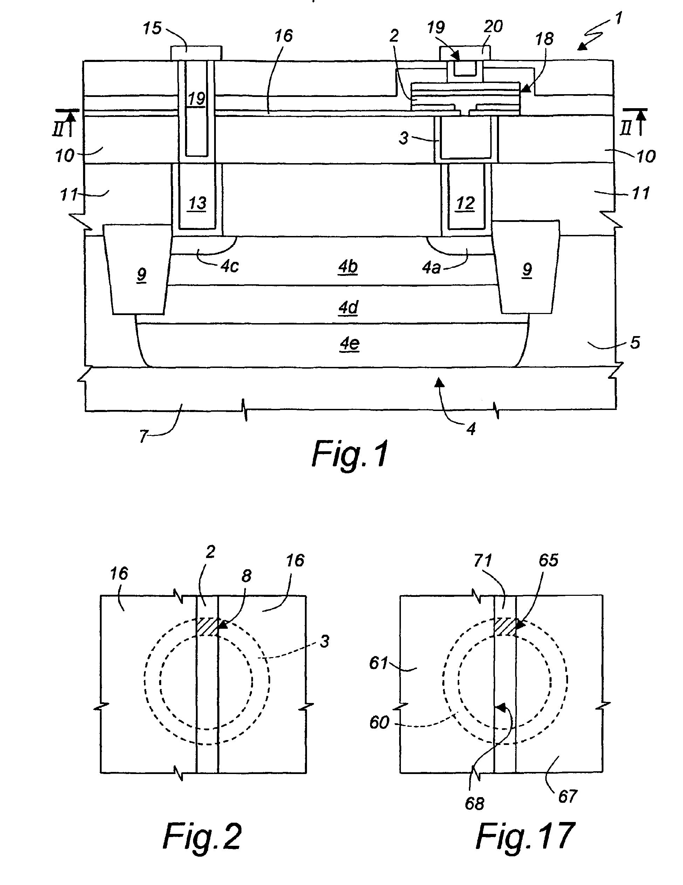

As already mentioned, bipolar selector transistors are coupled to the chalcogenic storage elements. For the sake of clarity, reference is made to figure 1, which illustrates a portion of a phase change memory device 1, comprising a chalcogenic strip 2, a cup-shaped heater 3, filled with dielectric material, and a selector 4; here, the selector 4 is a PNP bipolar transistor and is built in an epitaxial layer 5 grown over a substrate 7. In detail, the selector 4 comprises an emitter region 4a, a base region 4b, having a base contact region 4c, a collector region 4d and a sub-collector region 4e; moreover, the selector 4 is laterally delimited by trench isolation structures 9. A storage element 8 is defined at a contact region between the chalcogenic strip 2 and the heater 3, as schematically shown in figure 2. The heater 3 must be located a distance apart from the selector 4 and therefore is embedded in an upper dielectric layer 10, which is deposited on a lower dielectric layer 11. Moreover, the heater 3 is connected to the emitter region 4a of the selector 4 through a first plug 12, extending across the lower dielectric layer 11. A second plug 13 connects the base contact region 4c of the selector 4 to a word line 15.

According to known processes for fabricating phase change memories, the selector 4 is initially formed inside the epitaxial layer 5. Then, the lower dielectric layer 11 is deposited on the epitaxial layer 5 and the plugs 12, 13 are fabricated. More precisely, the lower dielectric layer 11 is anisotropically etched so as to form through openings, which are internally coated with a first conductive material and subsequently filled with a second conductive material.

The upper dielectric layer 10 is then deposited on the lower dielectric layer 11 and the heater 3 is made therein, by etching the upper dielectric layer 10, so as to open a cavity over the first plug 12, by coating the cavity with a material having a predetermined resistivity, thus contacting the first plug 12, and by filling the cavity again with dielectric material.

Thereafter, a delimiting layer 16 having an aperture is built on the upper dielectric layer 10; a chalcogenic layer is deposited on the delimiting layer 16 and fills the aperture, thereby forming the chalcogenic strip 2 and the storage element 8.

Finally, a metal line stack 18, second level plugs 19 and connection lines 20 are made, according to a required layout.

However, known processes have some limitations. First of all, a high number of fabrication steps are needed. For example, fabrication of the heater 3 preliminarily requires depositing the lower dielectric layer 11, for thermally insulating the selector 4 from the heater 3, forming the first plug 12 and the second plug 13 (i.e. etching the lower dielectric layer 11, internally coating and filling the openings), depositing and etching the upper dielectric layer 10; only at this stage of the process, resistive material can be deposited to form the heater 3.

Moreover, known processes can not provide high quality contacts between the terminals of the selector 4 and the storage element 8 or the connection lines. In fact, plugs 12, 13 land directly on doped epitaxial silicon of emitter region 4a and base contact region 4c, whereas further processing for making the surface of silicon contact regions highly conductive would be desirable.

It is clear that the above described drawbacks affect every type of memory using bipolar selector transistors coupled to the storage elements and not only phase change memories.

EP 1 318 552 A describing the state of the art in accordance with Art. 54(3) EPC discloses an example of a process for manufacturing a memory device wherein a phase change memory cell is coupled to a selection element which may be a bipolar transistor having embedded emitter and base regions and trench isolation structures.

EP 0 544 204 A shows an EEPROM device having a memory array implemented with a plurality of floating gate type memory transistors.

US 2002/03883 A discloses a phase-change memory device using diodes as selection elements.

US 4,922,318 A describes a bipolar transistor having raised contact.

The object of the invention is thus to provide a process for manufacturing memory devices and a memory device that overcome the above described drawbacks.

According to the present invention, a process for manufacturing a memory device having bipolar transistors as selectors for storage elements and a memory device fabricated thereby are provided, as defined respectively in claims 1 and 13.

For the understanding of the present invention, preferred embodiments thereof are now described, purely as non-limiting example, with reference to the enclosed drawings, wherein:
- figure 1 is a cross-sectional view of a memory device of a known type;
- figure 2 is a top plan view of a particular of figure 1, taken along line II-II of figure 1;
- figures 3-5 are cross-sections through a semiconductor wafer in successive manufacturing steps of a process according to a first embodiment of the present invention;
- figure 6 is a top plan view of the semiconductor wafer of figure 5;
- figures 7-16 are cross-sections through the semiconductor wafer of figure 5 in successive manufacturing steps;
- figure 17 is a top plan view of a particular of figure 16, taken along line XVII-XVII of figure 16; and
- figures 18-22 are cross-sections through a semiconductor wafer in successive manufacturing steps of a
process according to a second embodiment of the present invention.

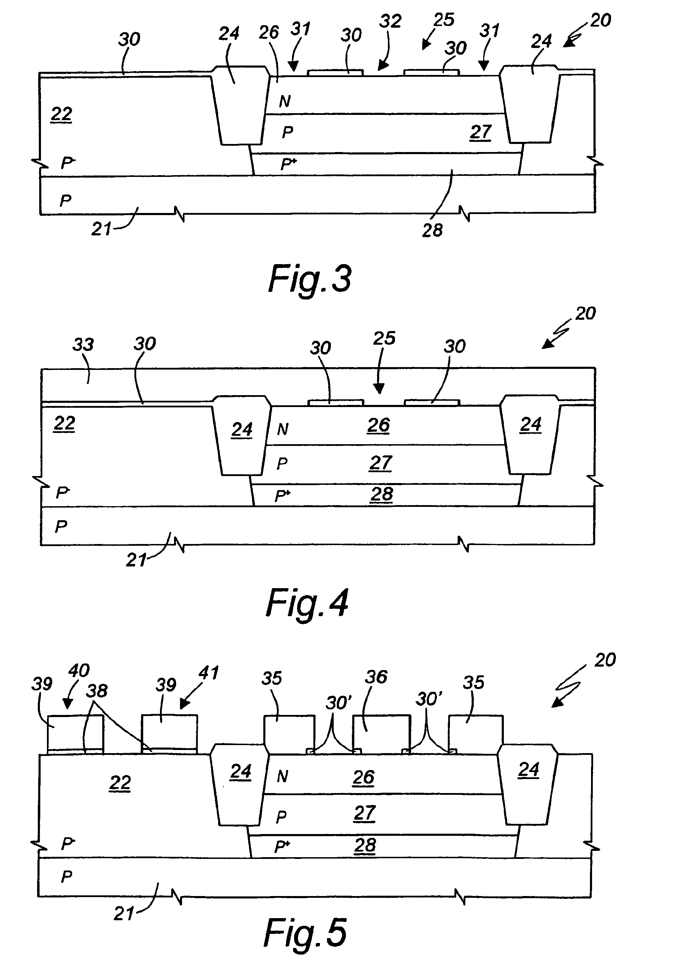

With reference to figure 3, a wafer 20 of semiconductor material comprises a substrate 21 and an epitaxial layer 22, for example of P type and of P- type, respectively. In an initial step of the process, a bipolar selector transistor 25 is formed within the epitaxial layer 22, in a per se known manner. In particular, the selector 25 is laterally delimited by trench isolation structures 24, preferably of silicon dioxide, and comprises a base region 26, of N type, a collector region 27, of P type, contiguous to the base region 26, and a sub-collector region 28, of P+ type and extending between the collector region 27 and the substrate 21.

A low-voltage gate oxide layer, hereinafter designed as LV oxide 30, is thermally grown on a whole surface 20a of the wafer 20 and is defined by a masked etch, so as to open emitter windows 31 and a base window 32, which partially expose corresponding contact areas of the base region 26. More precisely, the emitter windows 31 are formed at sides of the base region 26 and are adjacent to the trench isolation structures 24, whereas the base window 32 exposes a central portion of the base region 26.

Subsequently, a polysilicon layer 33 of preferably 100-300 nm is deposited on the wafer 20 and entirely covers the LV oxide 30, as shown in figure 4. In practice, the polysilicon layer 33 and the base region 26 are separated from each other by the LV oxide 30; however, the polysilicon layer 33 extends through the emitter windows 31 and the base window 32, thus reaching the base region 26 at the exposed contact areas.

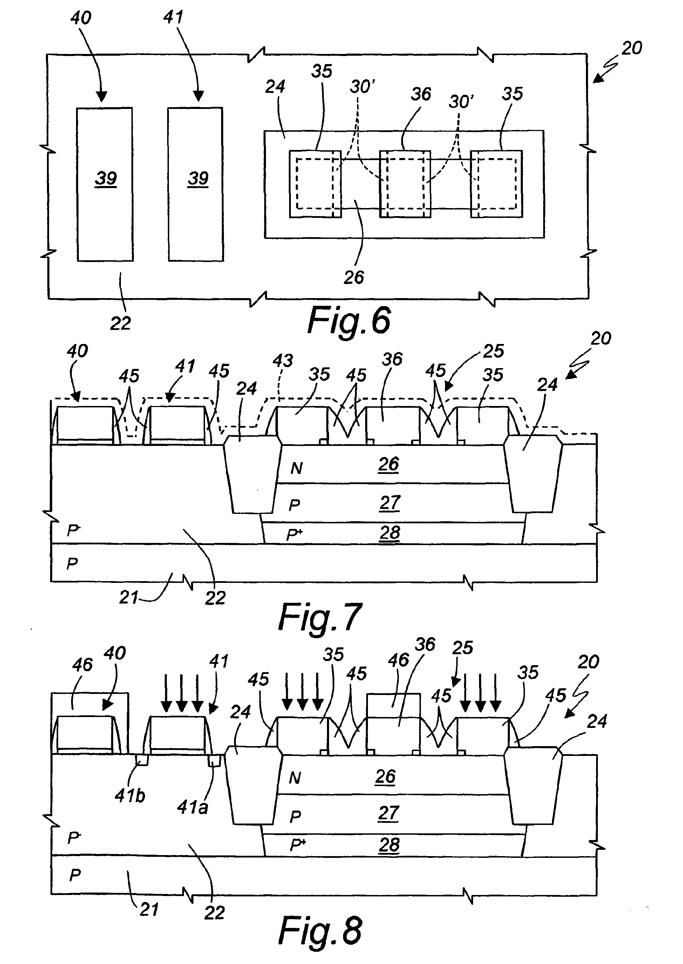

Thereafter (figure 5), the polysilicon layer 33 and the LV oxide 30 are selectively etched using a mask, here not illustrated. In detail, raised emitter regions 35 and a raised base region 36 are formed on the base region 26 of the selector 25, by removing the polysilicon layer 33 and the LV oxide 30 between the windows 31, 32. As shown in figure 6, the raised emitter regions 35 and a raised base region 36 slightly exceed the width of the base region 26. In this step, LV oxide 30 is at first used as a stop layer when the polysilicon layer 33 is etched, thus preventing the base region 26 from being damaged; then, the LV oxide 30 is etched as well. Raised emitter regions 35 and raised base region 36 are spaced by a predetermined distance, as explained hereinafter, and preferably overlap residual portions 30' of the LV oxide 30; such residual portions 30' are not removed to avoid the risk of leaving the base region 26 unprotected during polysilicon etch, on account of possible misalignments of the masks.

At the same time, on a circuitry portion of the wafer 20, which is schematically shown on the left of figures 3-16, gate oxide regions 38 and gate regions 39 of NMOS transistors 40 and PMOS transistors 41 are formed.

A protecting layer 43, e.g. of silicon dioxide, illustrated with a dotted line in figure 7, is then formed on the entire wafer 20 and is anisotropically etched. In particular, the protecting layer 43 is completely removed from substantially flat or smoothed portions of the wafer 20, whereas steep regions remain covered by spacers 45. In other words, around the edges of the raised emitter regions 35, of the raised base region 36, and of the gate regions 39, the height of the protecting layer 43 is much greater than elsewhere. Accordingly, the protecting layer 43 is only partially removed, when anisotropically etched, since only portions having lower thickness are completely ablated: so, the spacers 45 are formed and protect the underlying regions. Furthermore, the raised emitter regions 35 and the raised base region 36 are reciprocally spaced by such a distance that adjacent spacers 45 join together. Hence, the entire base region 26 is covered by either the raised regions 35, 36, or the spacers 45.

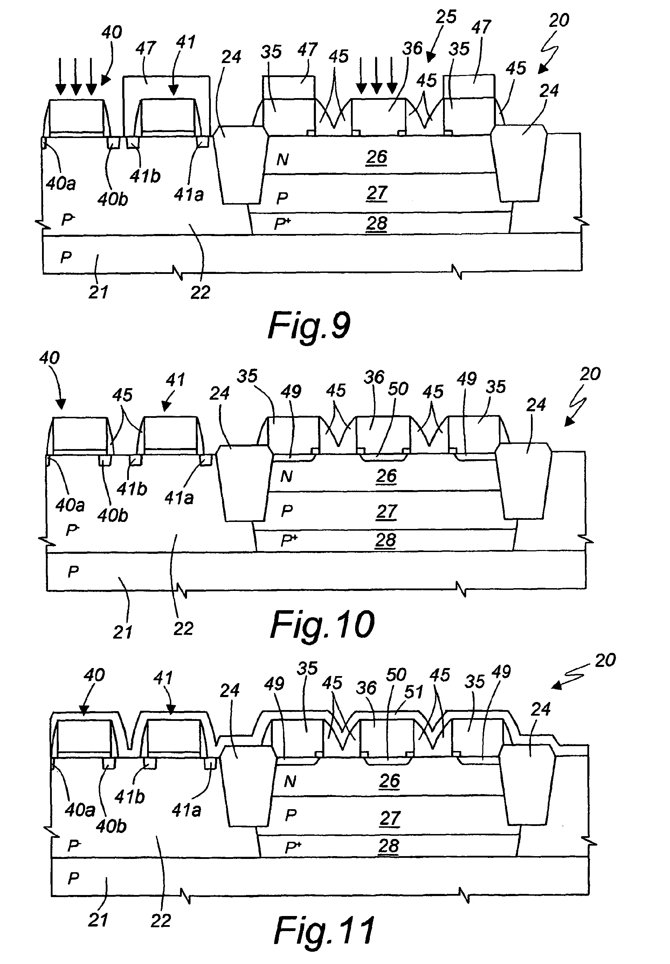

Subsequently, a P+ ion implantation and a N+ ion implantation are carried out (figures 8 and 9). More precisely, during the P+ ion implantation, the raised emitter regions 35 and the gate regions 39 of PMOS transistors 41 are exposed to receive implanted ions, and the raised base region 36 and the gate regions 39 of NMOS transistors 40 are protected by a first mask 46; on the contrary, during N+ ion implantation the raised base region 36 and the gate regions 39 of NMOS transistors 40 are exposed and the raised emitter regions 35 and the gate regions 39 of PMOS transistors 41 are protected by a second mask 47. Moreover, during P+ and N+ ion implantations also source regions 40a, 41a and drain regions 40b, 41b of the NMOS transistor 40 and of the PMOS transistor 41 are formed in the epitaxial layer 22 (source regions 40a, 40b and drain regions 41a, 41b are only schematically sketched).

After the ion implantations, the wafer 20 is heated for diffusing and activating the implanted ions, as illustrated in figure 10. In practice, in this step embedded emitter regions 49, of P+ type, and a base contact region 50, of N+ type, are formed within the base region 26 under the raised emitter regions 35 and under the raised base region 36, respectively.

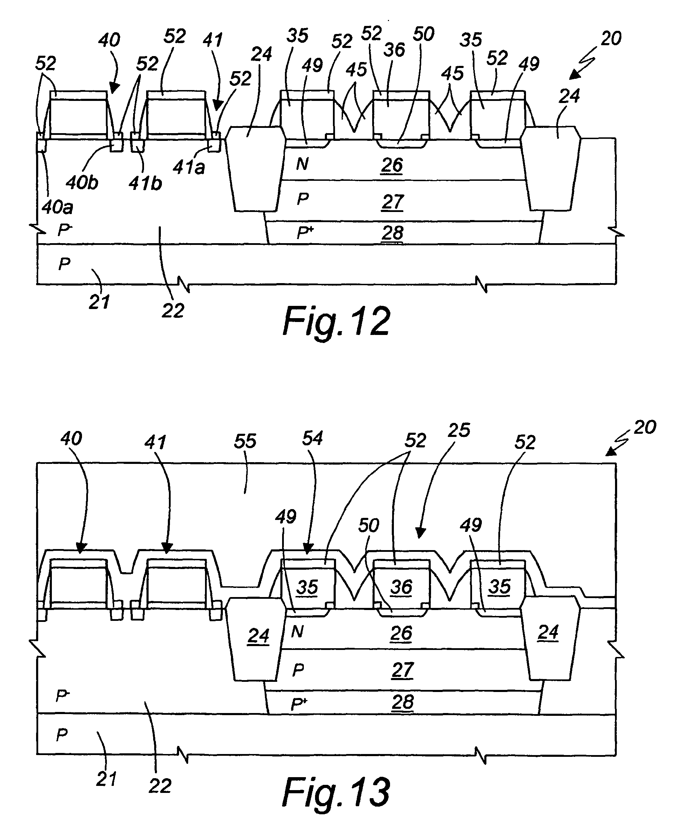

Then, a self-aligned silicidation step is carried out (figures 11 and 12). In greater detail, a metallic layer 51, e.g. of Ti, is deposited on the wafer 20, which is heated; in regions where the metallic layer 51 is in direct contact with polysilicon or silicon, i.e. on raised regions 35, 36 and on MOS transistors 40, 41, metallic silicide regions 52 are formed (figure 12), having higher conductivity than even heavily doped polysilicon, by a coefficient comprised between about 10 and 100; by a selective etch, the metallic layer 51 is removed, whereas the silicide regions 52 are left. In practice, the metallic layer 51 is locally changed to metallic silicide, by exploiting silicon atoms of the underlying raised emitter regions 35 and of the raised base region 36. The silicide regions 52 thus form high conductivity superficial layers of the raised emitter regions 35 and of the raised base region 36. Since the self-aligned silicidation step exploits the conformation of the top surface of the wafer 20 and conductive regions which must be preserved from silicidation are protected by the spacers 45, no anti-silicidation mask is required.

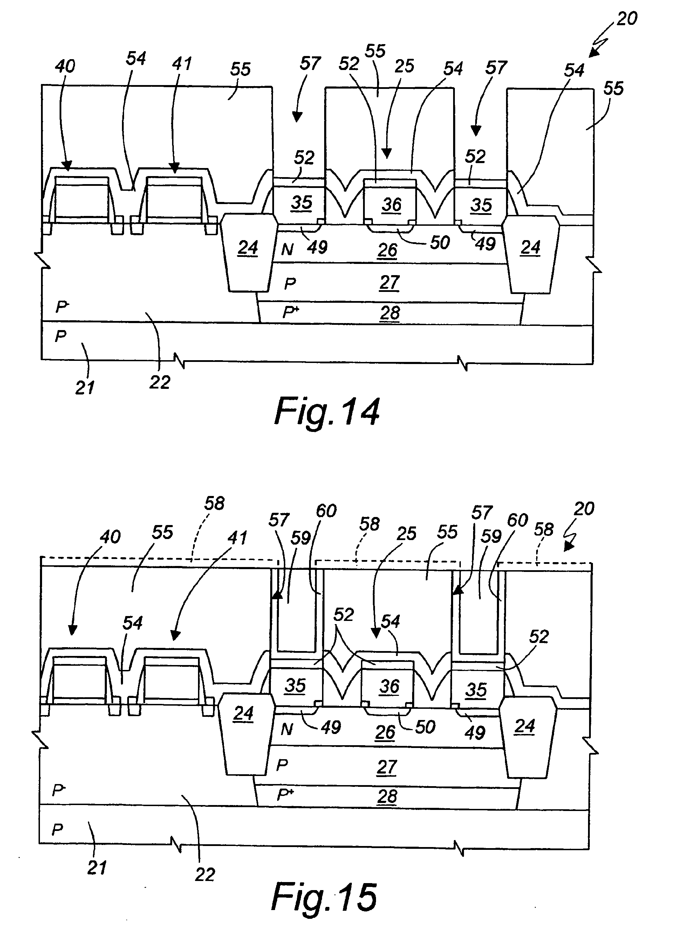

With reference to figure 13, a nitride layer 54 and a thick dielectric layer 55, higher than the raised regions 35, 36 and preferably made of silicon dioxide, are deposited on the wafer 20, which is then planarized, for example by CMP (Chemical-Mechanical-Polishing). Using a resist mask, not illustrated, the nitride layer 54 and the thick dielectric layer 55 are etched and first cavities 57 are opened, which extend down to the raised emitter regions 35, as shown in figure 14; more precisely, the first cavities 57 extend to the silicide regions 52 covering the raised emitter regions 35.

Subsequently, figure 15, a heating layer 58, having a predetermined resistivity, is deposited on the entire wafer 20 and coats the thick dielectric layer 55, walls of the first cavities 57 and the silicide regions 52 covering the raised emitter regions 35. Then, the first cavities 57 are filled with dielectric material 59. The dielectric material 59 and the heating layer 58 are removed by CMP from the thick dielectric layer 55 outside the first cavities 57. Residual portions of the heating layer 58 inside the first cavities 57 form heaters 60. Hence, heaters 60 are directly in contact with silicide regions 52 of respective raised emitter regions 35.

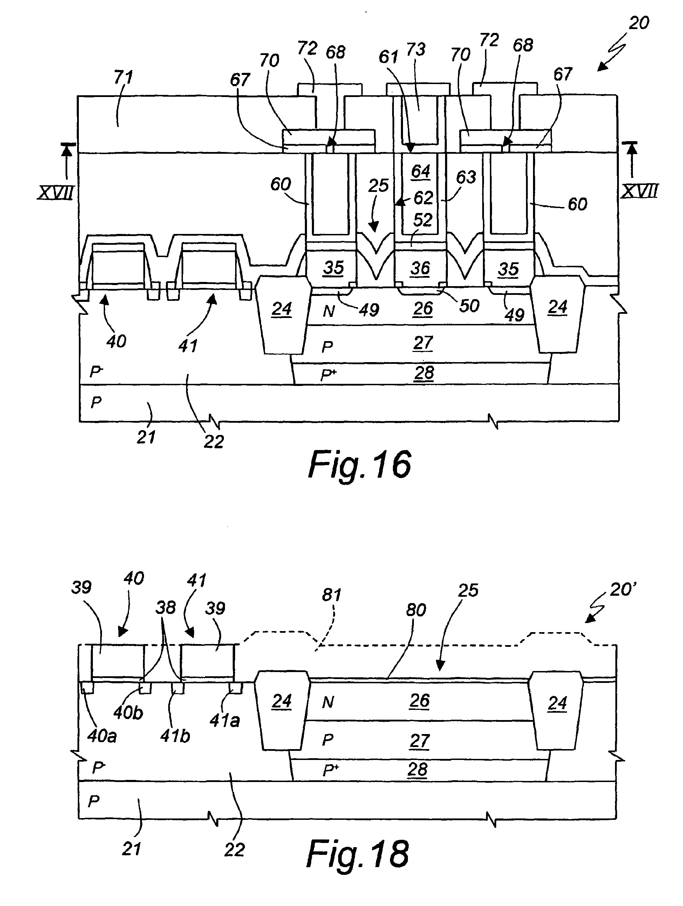

With reference to figure 16, a first level plug 61 is formed for providing electrical connection to the raised base region 36. In detail, a second cavity 62 is opened through the thick dielectric layer 55 and the nitride layer 54, so as to expose the silicide region 52 covering the raised base region 36; and a first conductive layer 63 is deposited inside the second cavity 62, which is filled with a second conductive layer 64.

Thereafter, storage elements 65 are made over the heaters 60 (se also figure 17), for example by forming a delimiting layer 67 having apertures 68 and by depositing and defining a chalcogenic layer 70, which fills the apertures 68. Accordingly, a memory device 75 is obtained, in which storage elements 65 are stacked on the selector 25 and the heaters 60; moreover, the storage elements 65 are connected to respective raised emitter regions 35 of the selector 25 through respective heaters 60.

Finally, an insulating layer 71 is deposited on the wafer 20; storage contacts 72 and a second level plug 73 are formed through insulating layer 71, so as to reach the storage elements 65 and the first level plug 61, respectively.

The advantages of the present invention are clear from the above. In particular, the process is quite simple with respect to the known processes. For example, in fact, silicidation step is self-aligned, since it is carried out exploiting the superficial conformation of the wafer and anti-silicidation mask is advantageously eliminated. Also, the heaters are made inside the dielectric layer which delimits the raised regions and therefore their fabrication does not require further deposition of dielectric layers.

Moreover, the present memory and manufacturing process allow a very efficient integration, completely compatible with CMOS technology and also with processes for the fabrication of chalcogenic storage elements with sublithographic dimension.

Also, selectors having raised emitter and/or base regions are provided, with high quality emitter and base contacts. In fact, raised regions can be easily silicided and the components that are coupled to the emitter and base contacts (i.e. heaters and first level plugs, respectively) land directly on silicide interfaces, which are much more conductive than polysilicon. Moreover, intermediate contacts are avoided.

A second embodiment of the present invention will be described hereinafter with reference to figures 18-22, where parts already shown are indicated with the same reference signs.

In the early stages of the process, the selector 25 is formed inside a wafer 20', which comprises the substrate 21, the epitaxial layer 22 and the trench isolation structures 24, as formerly described; moreover source regions 40a, 41a and drain regions 40b, 41b of transistors 40, 41 are formed in the substrate 22.

A LV oxide layer 80 and a polysilicon layer 81 are grown on the wafer 20' and selectively etched for defining the gate oxide regions 38 and gate regions 39 of transistors 40, 41. The polysilicon layer 81 is removed from the base region 26.

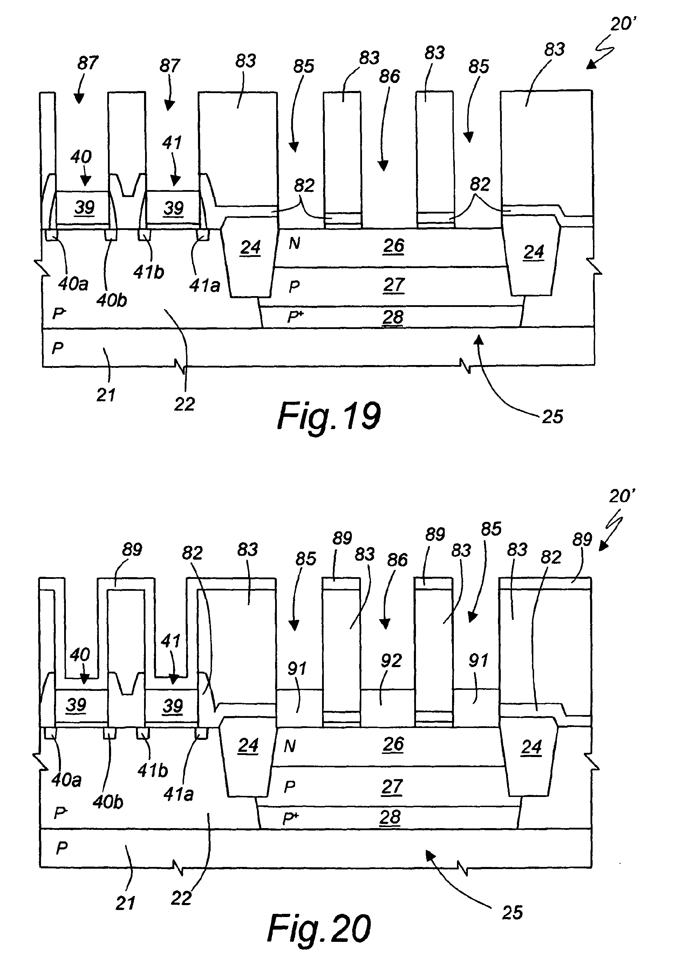

A nitride layer 82 and a dielectric layer 83 are then deposited, planarized by CMP and etched, so as to open emitter apertures 85 and a base aperture 86 over the base region 26, and gate apertures 87 over the gate regions 39 of the transistors 40, 41 (figure 19). The LV oxide layer 80 is then removed inside the emitter apertures 85 and the base aperture 86; hence, the base region 26 is partially exposed.

As illustrated in figure 20, a hard mask 89 is then formed, which protects the entire wafer 20', except the emitter apertures 85 and the base aperture 85. Later on, an epitaxial growth step is carried out, during which epitaxial regions are formed over exposed portions of the base region 26. In detail, the epitaxial regions comprise raised emitter regions 91, inside the emitter apertures 85, and a raised base region 92, inside the base aperture 86.

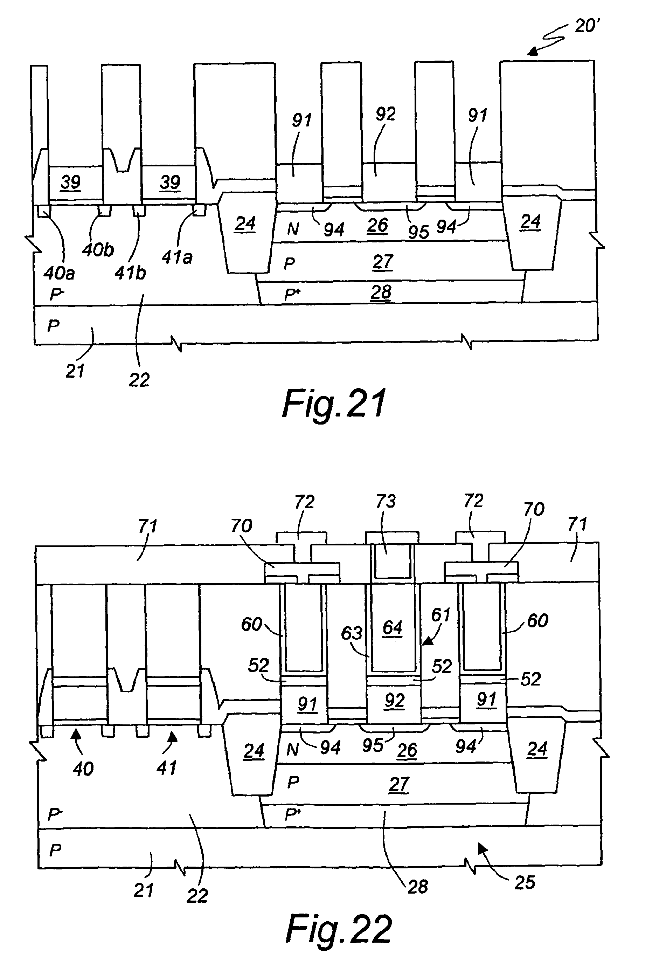

After removing the hard mask 89 (figure 21), P+ and N+ ion implantations are performed and implanted ions are then diffused and activated. Thus, embedded emitter regions 94, of P+ type, and a base contact region 95, of N+ type, are formed within the base region 26 under the raised emitter regions 91 and under the raised base region 92, respectively.

The process is then continued as already described. In particular, after a self-aligned silicidation step, the heaters 60, the storage elements 65 (see figure 17), the storage contacts 72 and the plugs 61, 73 are made, as shown in figure 22; a memory device 100 is thus obtained.

Finally, it is clear that numerous variations and modifications may be made to process and to the memory device described and illustrated herein, all falling within the scope of the invention as defined in the attached claims.

First, the process can be exploited for manufacturing any kind of memories that require bipolar selector transistors coupled to the storage elements, and not only phase change memories.

The selector 25 can comprise either a single raised emitter or even more than two raised emitters. Moreover, the selector 25 could have only raised emitter regions, whereas the base contact is of a standard type. In this case, the LV oxide 30 is removed only to open emitter windows 31 and is left elsewhere over the base region 26. After building the spacers 45, a portion of the base region 26 is exposed, so that it first receives N+ type dopant ions, and then is coated by a silicide region during silicidation. Also in this case, silicidation is self-aligned and anti-silicidation mask is not required. A deeper first level plug is formed later, since it has to go through all the thickness of the thick dielectric layer 55; anyway the quality of the base contact is not impaired.

When standard base contacts are made, the LV oxide 30 can be completely etched over the base region 26, before depositing the polysilicon layer 33 directly on the base region 26 itself. The polysilicon layer 33 is then etched as described, for defining the raised emitter regions 35 over the base region 26 and the gate regions 39 in circuitry area; the etch of the polysilicon layer 33 is stopped as soon as the residual LV oxide 30 in the circuitry area is reached and a slight over-etch of the base region 26 is accepted.

The first and second level plugs 61 and 73 can be replaced by a single level plug, thus simplifying the process.

At last, it is clear that the selector 25 can be also a bipolar NPN transistor.

## Claims

1. A process for manufacturing a memory device having selector transistors (25) with raised contacts, comprising the steps of:
- in a semiconductor body (20; 20'), forming at least a bipolar selector transistor (25), having at least an embedded base region (26), formed in said semiconductor body and laterally delimited by trench isolation structures (24), at least one embedded emitter region (49; 94), formed in said embedded base region (26), and a collector region (27), formed under and contiguous to said embedded base region (26); and
- forming at least a storage element (65), stacked on and electrically connected to said bipolar selector transistor (25);
wherein said step of forming at least a bipolar selector transistor (25) comprises forming at least a raised emitter region (35, 52; 91) of a semiconductor material, directly in contact with said embedded emitter region (49; 94), and a raised base region (36, 52; 92), of said semiconductor material, located on and electrically connected to said embedded base region (26).

2. A process according to claim 1, wherein said step of forming at least a raised emitter region comprises forming a plurality of raised emitter regions (35, 52; 91).

3. A process according to any one of the foregoing claims, wherein said step of forming at least a raised emitter region comprises the steps of:
- growing a separation layer (30) on said embedded base region (26);
- selectively etching said separation layer (30), for partially exposing said embedded base region (26);
- forming a conductive layer (33) on said separation layer (30), said conductive layer (33) reaching exposed areas of said embedded base region (26); and
- etching said conductive layer (33), substantially over said separation layer (30).

4. A process according to claim 3, wherein, after said step of etching said conductive layer (33), said separation layer (30) is removed.

5. A process according to claim 4, wherein said step of removing said separation layer (30) comprises leaving residual portions (30') of said separation layer (30) and wherein said step of etching said conductive layer (33) comprises leaving portions of said conductive layer (33) overlapping said residual portions (30').

6. A process according to any one of the claims 1 or 2, wherein said step of forming at least a raised emitter region comprises the steps of:
- forming a conductive layer (33) directly on said embedded base region (26); and
- etching said conductive layer (33).

7. A process according to any of the foregoing claims, wherein said raised emitter region (35, 52) and said raised base region (36, 52) are silicided.

8. A process according to claim 7, wherein, before siliciding said raised emitter region (35, 52) and said raised base region (36, 52), protective structures (45) are formed on sides of said raised emitter region (35) and said raised base region (36).

9. A process according to claims 1 and 8, wherein said raised emitter region (35, 52) and said raised base region (36, 52) are spaced by such a distance that adjacent protective structures (45) join together.

10. A process according to any one of the claims 1 or 2, wherein said step of forming at least a raised emitter region (91) comprises epitaxially growing said raised emitter region and said raised base region.

11. A process according to any one of the foregoing claims, wherein said step of forming a storage element (65) comprises forming a phase change storage element.

12. A process according to claim 11, wherein a heater (60) is formed directly in contact with said raised conductive region (35, 52; 91), and said storage element (65) is formed directly in contact with said heater (60).

13. A memory device comprising:
- a bipolar selector transistor (25), having at least an embedded base region (26), formed in a semiconductor body (20; 20') and laterally delimited by trench isolation structures (24), at least one embedded emitter region (49; 94), formed in said embedded base region (26), and a collector region (27), formed under and contiguous to said embedded base region (26); and
- at least a storage element (65), stacked on and electrically connected to said bipolar selector transistor (25);
wherein said bipolar selector transistor (25) comprises at least a raised emitter region (35, 52; 91) of a semiconductor material, formed directly in contact with said embedded emitter region, and a raised base region (36, 52; 92), of said semiconductor material, located on and electrically connected to said embedded base region (26).

14. A memory device according to claim 13, wherein said selector transistor (25) comprises a plurality of raised emitter regions (35, 52; 91).

15. A memory device according to any of the claims 13 or 14, wherein said raised emitter region (35, 52) and said base raised region (36, 52) have respective high conductivity superficial layers (52).

16. A memory device according to claim 15, wherein said high conductivity superficial layers (52) are metallic silicide layer.

17. A memory device according to any one of the claims 13-16, wherein said storage element (65) is a phase change storage element.

18. A memory device according to claim 17, wherein a heater (60) is located between said raised emitter region (35, 52) and said storage element (65), said heater (60) being directly in contact with said raised emitter region (35, 52) and with said storage element (65).

## Patentansprüche

1. Verfahren zum Herstellen einer Speichervorrichtung, die Auswahltransistoren (25) mit erhabenen Kontakten aufweist, wobei das Verfahren folgende Schritte aufweist:
- in einem Halbleiterkörper (20; 20') erfolgende Bildung von mindestens einem bipolaren Auswahltransistor (25), der mindestens einen eingebetteten Basisbereich (26), der in dem Halbleiterkörper (20; 20') gebildet ist und in seitlicher Richtung durch Grabenisolierstrukturen (24) abgegrenzt ist, mindestens einen eingebetteten Emitterbereich (49; 94), der in dem eingebetteten Basisbereich (26) gebildet ist, sowie einen Kollektorbereich (27) aufweist, der unter dem eingebetteten Basisbereich (26) gebildet ist und sich an diesen anschließt; und
- Bilden von mindestens einem Speicherelement (65), das stapelartig auf dem bipolaren Auswahltransistor (25) angeordnet ist und mit diesem elektrisch verbunden ist;
wobei der Schritt des Bildens von mindestens einem bipolaren Auswahltransistor (25) das Bilden von mindestens einem erhabenen Emitterbereich (35, 52; 91) aus einem Halbleitermaterial in direkter Berührung mit dem eingebetteten Emitterbereich (49; 94) sowie das Bilden von einem erhabenen Basisbereich (36, 52; 92) aus dem Halbleitermaterial umfasst, der auf dem eingebetteten Basisbereich (26) angeordnet und mit diesem elektrisch verbunden ist.

2. Verfahren nach Anspruch 1,
wobei der Schritt des Bildens von mindestens einem erhabenen Emitterbereich das Bilden einer Mehrzahl von erhabenen Emitterbereichen (35, 52; 91) umfasst.

3. Verfahren nach einem der vorausgehenden Ansprüche,
wobei der Schritt des Bildens von mindestens einem erhabenen Emitterbereich folgende Schritte aufweist:
- Wachsen Lassen einer Trennschicht (30) auf dem eingebetteten Basisbereich (26);
- selektives Ätzen der Trennschicht (30) zum partiellen Freilegen des eingebetteten Basisbereichs (26);
- Bilden einer leitfähigen Schicht (33) auf der Trennschicht (30), wobei die leitfähige Schicht (33) freiliegende Bereiche des eingebetteten Basisbereichs (26) erreicht; und
- Ätzen der leitfähigen Schicht (33) im Wesentlichen über die Trennschicht (30) hinweg.

4. Verfahren nach Anspruch 3,
wobei nach dem Schritt des Ätzens der leitfähigen Schicht (33) die Trennschicht (30) entfernt ist.

5. Verfahren nach Anspruch 4
wobei der Schritt des Entfernens der Trennschicht (30) das Belassen von Restbereichen (30') der Trennschicht (30) umfasst und wobei der Schritt des Ätzens der leitfähigen Schicht (33) das Belassen von die Restbereiche (30') überlappenden Bereichen der leitfähigen Schicht (33) umfasst.

6. Verfahren nach einem der Ansprüche 1 oder 2,
wobei der Schritt des Bildens von mindestens einem erhabenen Emitterbereich folgende Schritte umfasst:
- Bilden einer leitfähigen Schicht (33) direkt auf dem eingebetteten Basisbereich (26); und
- Ätzen der leitfähigen Schicht (33).

7. Verfahren nach einem der vorausgehenden Ansprüche,
wobei der erhabene Emitterbereich (35, 52) und der erhabene Basisbereich (36, 52) silizidiert werden.

8. Verfahren nach Anspruch 7,
wobei vor der Silizidierung des erhabenen Emitterbereichs (35, 52) und des erhabenen Basisbereichs (36, 52) Schutzstrukturen (45) an den Seiten des erhabenen Emitterbereichs (35) und des erhabenen Basisbereichs (36) gebildet werden.

9. Verfahren nach Anspruch 1 und 8,
wobei der erhabene Emitterbereich (35, 52) und der erhabene Basisbereich (36, 52) über eine derartige Distanz voneinander beabstandet sind, dass einander benachbarte Schutzstrukturen (45) miteinander in Verbindung stehen.

10. Verfahren nach einem der Ansprüche 1 oder 2,
wobei der Schritt der Bildung von mindestens einem erhabenen Emitterbereich (91) das epitaxiale Wachsen Lassen des erhabenen Emitterbereichs und des erhabenen Basisbereichs umfasst.

11. Verfahren nach einem der vorausgehenden Ansprüche,
wobei der Schritt der Bildung eines Speicherelements (65) das Bilden eines Phasenveränderungs-Speicherelements umfasst.

12. Verfahren nach Anspruch 11,
wobei eine Heizeinrichtung (60) in direkter Berührung mit dem erhabenen leitfähigen Bereich (35, 52; 91) gebildet wird und das Speicherelement (65) in direkter Berührung mit der Heizeinrichtung (60) gebildet wird.

13. Speichervorrichtung, aufweisend:
- einen bipolaren Auswahltransistor (25), der mindestens einen eingebetteten Basisbereich (26), der in einem Halbleiterkörper (20; 20') gebildet ist und in seitlicher Richtung durch Grabenisolierstrukturen (24) abgegrenzt ist, mindestens einen eingebetteten Emitterbereich (49; 94), der in dem eingebetteten Basisbereich (26) gebildet ist, sowie einen Kollektorbereich (27) aufweist, der unter dem eingebetteten Basisbereich (26) gebildet ist und sich an diesen anschließt; und
- mindestens ein Speicherelement (65), das stapelartig auf dem bipolaren Auswahltransistor (25) angeordnet ist und mit diesem elektrisch verbunden ist;
wobei der bipolare Auswahltransistor (25) mindestens einen erhabenen Emitterbereich (35, 52; 91) aus einem Halbleitermaterial, der in direkter Berührung mit dem eingebetteten Emitterbereich gebildet ist, sowie einen erhabenen Basisbereich (36, 52; 92) aus dem Halbleitermaterial aufweist, der auf dem eingebetteten Basisbereich (26) angeordnet und mit diesem elektrisch verbunden ist.

14. Speichervorrichtung nach Anspruch 13,
wobei der Auswahltransistor (25) eine Mehrzahl von erhabenen Emitterbereichen (35, 52; 91) aufweist.

15. Speichervorrichtung nach einem der Ansprüche 13 oder 14,
wobei der erhabene Emitterbereich (35, 52) und der erhabene Basisbereich (36, 52) jeweils eine Oberflächenschicht (52) mit hoher Leitfähigkeit aufweisen.

16. Speichervorrichtung nach Anspruch 15,
wobei es sich bei den Oberflächenschichten (52) mit hoher Leitfähigkeit um metallische Silizidschichten handelt.

17. Speichervorrichtung nach einem der Ansprüche 13 bis 16,
wobei es sich bei dem Speicherelement (65) um ein Phasenveränderungs-Speicherelement handelt.

18. Speichervorrichtung nach Anspruch 17,
wobei eine Heizeinrichtung (60) sich zwischen dem erhabenen Emitterbereich (35, 52) und dem Speicherelement (65) befindet, wobei die Heizeinrichtung (35, 52) mit dem erhabenen Emitterbereich (35, 52) und mit dem Speicherelement (65) in direkter Berührung steht.

## Revendications

1. Procédé de fabrication d'un dispositif de mémoire comprenant des transistors de sélection (25) avec des contacts relevés, comprenant les étapes consistant à :
- dans un corps semi-conducteur (20 ; 20'), former au moins un transistor de sélection bipolaire (25), ayant au moins une région de base encastrée (26), formée dans ledit corps semi-conducteur et délimitée latéralement par des structures d'isolation de tranchée (24), au moins une région d'émetteur encastrée (49 ; 94), formée dans ladite région de base encastrée (26), et une région de collecteur (27), formée sous et contiguë à ladite région de base encastrée (26) ; et
- former au moins un élément de stockage (65), empilé sur et connecté électriquement avec ledit transistor de sélection bipolaire (25) ;
dans lequel ladite étape de formation d'au moins un transistor de sélection bipolaire (25) consiste à former au moins une région d'émetteur relevée (35, 52 ; 91) d'un matériau semi-conducteur, directement en contact avec ladite région d'émetteur encastrée (49 ; 94), et une région de base relevée (36, 52 ; 92), dudit matériau semi-conducteur, située sur et connectée électriquement à ladite région de base encastrée (26).

2. Procédé selon la revendication 1, dans lequel ladite étape de formation d'au moins une région d'émetteur relevée consiste à former une pluralité de régions d'émetteur relevées (35, 52 ; 91).

3. Procédé selon l'une quelconque des revendications précédentes, dans lequel ladite étape de formation d'au moins une région d'émetteur relevée comprend les étapes consistant à :
- faire croître une couche de séparation (30) sur ladite région de base encastrée (26) ;
- graver sélectivement ladite couche de séparation (30), pour exposer partiellement ladite région de base encastrée (26) ;
- former une couche conductrice (33) sur ladite couche de séparation (30), ladite couche conductrice (33) atteignant des zones exposées de ladite région de base encastrée (26) ; et
- graver ladite couche conductrice (33), sensiblement sur ladite couche de séparation (30).

4. Procédé selon la revendication 3, dans lequel, après l'étape de gravure de ladite couche conductrice (33), ladite couche de séparation (30) est enlevée.

5. Procédé selon la revendication 4, dans lequel ladite étape d'enlèvement de ladite couche de séparation (30) consiste à laisser des parties résiduelles (30') de ladite couche de séparation (30) et dans lequel ladite étape de gravure de ladite couche conductrice (33) consiste à laisser des parties de ladite couche conductrice (33) recouvrant lesdites parties résiduelles (30').

6. Procédé selon l'une quelconque des revendications 1 ou 2, dans lequel ladite étape de formation d'au moins une région d'émetteur relevée comprend les étapes consistant à :
- former une couche conductrice (33) directement sur ladite région de base encastrée (26) ; et
- graver ladite couche conductrice (33).

7. Procédé selon l'une quelconque des revendications précédentes, dans lequel ladite région d'émetteur relevée (35, 52) et ladite région de base relevée (36, 52) sont traitées au siliciure.

8. Procédé selon la revendication 7, dans lequel, avant de traiter au siliciure ladite région d'émetteur relevée (35, 52) et ladite région de base relevée (36, 52), des structures protectrices (45) sont formées sur des côtés de ladite région d'émetteur relevée (35) et ladite région de base relevée (36).

9. Procédé selon les revendications 1 et 8, dans lequel, ladite région d'émetteur relevée (35, 52) et ladite région de base relevée (36, 52) sont espacées d'une distance telle que des structures protectrices adjacentes (45) soient unies entre elles.

10. Procédé selon l'une quelconque des revendications 1 ou 2, dans lequel ladite étape de formation d'au moins une région d'émetteur relevée (91) comprend la croissance épitaxiale de ladite région d'émetteur relevée et ladite région de base relevée.

11. Procédé selon l'une quelconque des revendications précédentes, dans lequel ladite étape de formation d'un élément de stockage (65) consiste à former un élément de stockage à changement de phase.

12. Procédé selon la revendication 11, dans lequel un élément de chauffage (60) est formé directement en contact avec ladite région conductrice relevée (35, 52 ; 91) et ledit élément de stockage (65) est formé directement en contact avec ledit élément de chauffage (60).

13. Dispositif de mémoire comprenant :
- un transistor de sélection bipolaire (25), ayant au moins une région de base encastrée (26), formée dans un corps semi-conducteur (20 ; 20') et délimitée latéralement par des structures d'isolation de tranchée (24), au moins une région d'émetteur encastrée (49 ; 94), formée dans ladite région de base encastrée (26), et une région de collecteur (27), formée sous et contiguë à ladite région de base encastrée (26) ; et
- au moins un élément de stockage (65), empilé sur et connecté électriquement avec ledit transistor de sélection bipolaire (25) ;
dans lequel ledit transistor de sélection bipolaire (25) comprend au moins une région d'émetteur relevée (35, 52 ; 91) d'un matériau semi-conducteur, formée directement en contact avec ladite région d'émetteur encastrée, et une région de base relevée (36, 52 ; 92), dudit matériau semi-conducteur, située sur et connectée électriquement à ladite région de base encastrée (26).

14. Dispositif de mémoire selon la revendication 13, dans lequel ledit transistor de sélection (25) comprend une pluralité de régions d'émetteur relevées (35, 52 ; 91).

15. Dispositif de mémoire selon l'une quelconque des revendications 13 ou 14, dans lequel ladite région d'émetteur relevée (35, 52) et ladite région de base relevée (36, 52) ont des couches superficielles à haute conductivité (52) respectives.

16. Dispositif de mémoire selon la revendication 15, dans lequel lesdites couches superficielles à haute conductivité (52) sont des couches de siliciure métalliques.

17. Dispositif de mémoire selon l'une quelconque des revendications 13 à 16, dans lequel ledit élément de stockage (65) est un élément de stockage à changement de phase.

18. Dispositif de mémoire selon la revendication 17, dans lequel un élément de chauffage (60) est situé entre ladite région d'émetteur relevée (35, 52) et ledit élément de stockage (65), ledit élément de chauffage (60) étant directement en contact avec ladite région d'émetteur relevée (35, 52) et ledit élément de stockage (65).
